# EUROPÄISCHE PATENTANMELDUNG

(11) **EP 1 750 297 A2**
(43) Veröffentlichungstag der Anmeldung: **07.02.2007**
(21) Anmeldenummer: 06013986.2
(22) Anmeldetag: 06.07.2006
(51) Int. Cl.: H01L 21/324, H01L 21/265

(54) **Verfahren zur Behandlung von Halbleitersubstratoberflächen, die mittels intensiven Lichtimpulsen kurzzeitig aufgeschmolzen werden**

(30) Priorität: 04.08.2005 DE 102005036669
(71) Anmelder: Forschungszentrum Rossendorf e.V., 01328 Dresden (DE)
(72) Erfinder: Voelskow, Matthias, Dr., 01279 Dresden (DE); Skorupa, Wolfgang, Dr., 01108 Dresden (DE); Anwand, Wolfgang, 01328 Dresden (DE)

(57) **Zusammenfassung**

Die Erfindung betrifft ein Verfahren zur Behandlung von Halbleitersubstraten, die mittels intensiven Lichtimpulsen bestrahlt werden, insbesondere zum kurzzeitigen und gleichmäßigen Aufschmelzen einer dünnen Halbleiteroberflächenschicht. Die Erfindung soll vorzugsweise zur Herstellung elektronischer Bauelemente eingesetzt werden.

Die Aufgabe der Erfindung besteht darin, den Vertikalaufbau der mit Hilfe der Lichtimpulsbestrahlung zu schmelzenden Substrat-Oberflächenschicht so zu modifizieren, dass eine weitgehend ebene Schmelzfront erreicht wird.

Die erfindungsgemäße Lösung beinhaltet, dass auf der Halbleitersubstratoberfläche vor der Lichtimpulsbehandlung eine im Schmelzpunkt gegenüber dem Substrat erniedrigte epitaktische Halbleiterschicht erzeugt wird.

## Beschreibung

Die Erfindung betrifft ein Verfahren zur Behandlung von Halbleitersubstraten, die mittels intensiven Lichtimpulsen bestrahlt werden, insbesondere zum kurzzeitigen und gleichmäßigen Aufschmelzen einer dünnen Halbleiteroberflächenschicht. Die Erfindung soll vorzugsweise zur Herstellung elektronischer Bauelemente eingesetzt werden.

Sowohl die Impulsausheilung heteroepitaktischer Halbleiterschichtsysteme, beispielsweise epitaktisch abgeschiedener dünner Siliziumkarbidschichten auf einkristallinen Siliziumsubstraten zur Verbesserung der Eigenschaften der SiC-Epitaxieschichten (W. Skorupa, D. Panknin, M. Voelskow, W. Anwand, T. Gebel, R. A. Yankov, S. Paul, W. Lerch, MRS Spring Meeting, San Francisco, April 2004), als auch die Ausheilung einkristalliner Siliziumoberflächen zur Eliminierung von Strahlenschäden durch eine vorangegangene Ionenimplantation und zur Einstellung bestimmter Fremdatomprofile mit intensiven Lichtimpulsen, wie sie unter anderem durch Laser oder Blitzlampen erzeugt werden (E. Rimini, P. Baeri, G. Russo, Fundamental of laser pulse irradition of silicon, Proc. Int. Conf. on Energy Pulse Modification of Materials, Dresden, 1984) basieren auf dem kurzzeitigen Aufschmelzen einer dünnen Siliziumoberflächenschicht und deren anschließender epitaktischer Kristallisation auf dem nichtgeschmolzenen Material.

Die Vorteile der Siliziumkarbid-Ausheilung unter Anschmelzen der Silizium- Substratoberfläche gegenüber der üblichen reinen Festphasenausheilung, bestehen dabei darin,
dass sich die aufgrund des vorangegangenen Festphasenepitaxieprozesses mechanisch stark verspannte SiC-Grenzflächenschicht zum Silizium durch das Anschmelzen der Silizium-Schicht vollständig entspannen kann,
dass die Haltezeit auf einer für die Ausheilung von Kristallschäden in der abgeschiedenen SiC-Schicht günstigen, aber für die übliche, konventionelle Festphasenausheilung nicht realisierbaren hohen Temperatur von ca. 1400 °C, über die eigentliche Impulszeit hinaus, verlängert wird, da die in der geschmolzenen Si-Schicht in Form von latenter Wärme gespeicherte Energie, nachdem der Lichtimpuls bereits vorüber ist, bei der Kristallisation wieder abgegeben wird und der Abkühlung entgegenwirkt,
dass eine laterale Temperaturhomogenisierung stattfindet, da bereits angeschmolzenes Material einen höheren Reflexionskoeffizienten besitzt und der Energieeintrag an dieser Stelle gegenüber noch nicht geschmolzenem Material reduziert ist und
dass das flüssige Silizium epitaktisch an der Grenzfläche zum festen Silizium kristallisiert, wobei der Einkristall wiederhergestellt wird.

Die Vorteile der Bestrahlung von ionenimplantierten Halbleiteroberflächen gegenüber den üblichen Ausheilverfahren in der festen Phase bestehen darin, dass sich, in Abhängigkeit vom Segregationskoeffizienten der ionenimplantierten Fremdatome, ganz bestimmte extreme Profilverläufe, wie Rechteckprofile oder sehr steile, oberflächennahe Profile über das kurzzeitige Anschmelzen der Oberfläche erzeugen lassen.

Auf konventionelle Weise lassen sich Rechteckprofile nur durch aufwendige Mehrfachimplantationen herstellen. Extrem oberflächennahe, steile Profile lassen sich wiederum, sowohl aufgrund von stets vorhandener geringer, jedoch unkontrollierbarer Oberflächenkontaminationen, als auch aufgrund der technologisch schwer beherrschbaren Niederenergieimplantation, nur mit sehr großem Aufwand realisieren.

In der Praxis erweist sich aber, dass das rapide Anschmelzen dünner Halbleiteroberflächenschichten mittels Energieimpulsen zwar prinzipiell funktioniert, jedoch führt die aufgrund der Abhängigkeit der Schmelzgeschwindigkeit von der kristallographischen Richtung auftretende facettierte und damit nicht ebenen Schmelzfront dazu, dass sich bei der anschließend folgenden Erstarrung, aufgrund lateraler Wachstumskomponenten an der fest flüssigen Phasenfront und aufgrund der Volumenzunahme bei der Erstarrung von flüssigem Silizium, ein Oberflächenrelief ausbildet. Dabei wird, im Anwendungsfall der heteroepitaktischen SiC-Schichten, die oberflächliche auszuheilende SiC-Schicht geschädigt. Für den Anwendungsfall der gezielten Profileinstellung durch Blitzlampenbestrahlung nach Ionenimplantation wird dadurch ein lateral ungleichmäßiges Tiefenprofil der Dotanden erzeugt. Dieses für die Bestrahlung von einkristallinen Oberflächen mit kurzen Energieimpulsen typische Phänomen der sogenannten Schmelzkeimbildung, wurde bereits beschrieben (K.-H. Heinig, Effect of local melting on semiconductor surfaces, Proc. Int. Conf. on Energy Pulse Modification of Materials, Dresden, 1984).

Die Aufgabe der Erfindung besteht darin, den Vertikalaufbau der mittels der Lichtimpulsbestrahlung zu schmelzenden Oberflächenschichten so zu modifizieren, dass eine weitgehend ebene und nicht facettierte Schmelzfront erreicht wird.

Erfindungsgemäß wird die Aufgabe mit den in den Patentansprüchen dargelegten Merkmalen gelöst.

Dabei ist wesentlich, dass die Ausbildung der tiefreichenden Schmelzkeime in der Siliziumoberfläche in der Folge der Blitzlampenbestrahlung verhindert wird. Das geschieht dadurch, dass vor der Blitzlampenbestrahlung in der Silizium-Oberflächenschicht, beispielsweise durch Ionenimplantation, eine den Schmelzpunkt des Siliziums um mindestens zehn Grad erniedrigende Schicht erzeugt wird, die in ihrer Struktur der des Siliziums ähnelt und die bei der Blitzlampenbestrahlung in ihrer gesamten Tiefe homogen aufgeschmolzen wird, ohne dass dabei tiefer liegende Siliziumbereiche, welche bei der Ionenimplantation nicht erreicht wurden, mit angeschmolzen werden.

Eine derartige, im Schmelzpunkt erniedrigte Schicht kann beispielsweise, im Anwendungsfall der Ausheilung von SiC-/ Si-Strukturen, durch Ionenimplantation von Germanium durch eine dünne (< 50 nm) Siliziumkarbidschicht bei einer Temperatur von 500 °C und einer Ionendosis im Bereich von 10¹⁷ cm⁻² erzeugt werden. Die hohe Implantationstemperatur verhindert dabei eine zusätzliche Schädigung der ohnehin nach der Abscheidung stark gestörten SiC-Epitaxieschicht. Die schmelzpunkterniedrigte Zwischenschicht kann jedoch auch vor der eigentlichen Abscheidung der SiC-Schicht durch eine zusätzliche epitaktische Abscheidung einer germaniumreichen Siliziumschicht erzeugt werden.

Bildet sich während der Blitzlampenbestrahlung ein Schmelzkeim in der Ge-angereicherten kristallinen Siliziumoberfläche, so wächst er von der Oberfläche aus zunächst dreidimensional (in Form einer kopfstehenden Pyramide), bis seine Spitze auf den unimplantierten Siliziumbereich in der Tiefe trifft. Da aufgrund des im Vergleich zur Ge-implantierten Schicht höheren Schmelzpunktes des hinter der implantierten Schicht liegenden reinen Siliziums, ein vertikales Fortschreiten der Schmelze verlangsamt, oder bei entsprechender Wahl der Bestrahlungsenergie, gänzlich gestoppt wird, kann der einzelne Schmelzkeim nur noch in die Breite wachsen, wo er anschließend auf den nächsten trifft und so weiter, was schließlich zur Ausbildung einer dünnen, ebenen und geschlossenen flüssigen Siliziumschicht führt.

Nachdem der Lichtimpuls vorüber ist und das Schichtsystem beginnt, sich abzukühlen, setzt das epitaktische Wachstum des Siliziums an der ebenen Grenzfläche zum reinen fest gebliebenen Silizium ein und setzt sich in Richtung Oberfläche fort.

Während im Fall der unimplantierten Strukturen das Wachstum aufgrund der Schmelzkeimbildung und der dabei entstehenden facettierten flüssig/festen Grenzfläche stets eine laterale Komponente besitzt und damit aufgrund der unterschiedlichen Dichten von flüssigem und festem Silizium auch ein lateraler Massetransport erfolgt, bewegt sich hierbei die Erstarrungsfront erfindungsgemäß in der gleichmäßig ausgebildeten, sehr dünnen und ebenen geschmolzenen Siliziumschicht ausschließlich in vertikaler Richtung. Ein lateraler Massetransport erfolgt dabei nicht.

Im Ergebnis der Blitzlampenbestrahlung mit Energiedichten, welche ausreichend sind für das Anschmelzen der Ge-legierten und damit im Schmelzpunkt erniedrigten Siliziumoberflächen, jedoch nicht ausreichen zum Schmelzen des nicht implantierten Teils des Siliziumsubstrates, wird damit erfindungsgemäß nach der Erstarrung eine ebene und kristalline Substratoberfläche erhalten. Dabei kann durch die Wahl der Höhe der Ge-Konzentration im Silizium die Schmelztemperatur in der Oberflächenschicht definiert eingestellt werden und außerdem durch die Wahl der Implantationsenergie die Dicke der homogen geschmolzenen Oberflächenschicht vorgegeben werden. Für den Fall, dass sich oberhalb der Ge-dotierten Si- Schicht eine abgeschiedene, epitaktische Siliziumkarbidschicht befindet, führt das gleichmäßige Anschmelzen der darunter liegenden Ge-legierten Schicht dazu, dass sich die, aufgrund der Gitterfehlanpassung zwischen Si und SiC nach der SiC-Abscheidung stets stark verspannte SiC-Schicht, mechanisch entspannen kann.

Des weiteren ist es auch möglich, dass vor der Bestrahlung in die Oberflächenschicht zusätzlich zum Germanium ein chemisch gut lösliches Element, wie Bor, implantiert wird, das sich während der Schmelze homogen über die Schichtdicke verteilt und bei der anschließenden Erstarrung diese homogene Verteilung beibehält.

Andererseits können auch vor der Bestrahlung in die Oberflächenschicht zur Segregation (an einer flüssig/festen Erstarrungsfront) neigende Dotierungsatome, wie beispielsweise Antimon in Silizium, z. B. durch Ionenimplantation, eingebracht werden, welche während der ganzflächigen, homogenen Schmelze und anschließenden Erstarrung in die unmittelbare Oberflächenschicht segregieren, wodurch eine sehr dünne und sehr hoch dotierte, oberflächennahe Halbleiterschicht erzeugt wird.

Der hauptsächliche Vorteil des vorgeschlagenen Verfahrens unter Zuhilfenahme beispielsweise einer den Schmelzpunkt des Siliziumsubstrates erniedrigenden Implantation gegenüber der Bestrahlung von reinen Si-Oberflächen bzw. Grenzflächen, besteht in der gezielten Begrenzung und Homogenisierung der Schmelztiefe des Substrates als Voraussetzung für die Erhaltung einer ebenen Oberfläche des Systems nach der Erstarrung der geschmolzenen Oberflächenschicht.

Die Erfindung wird nachstehend an einem Ausführungsbeispiel näher erläutert.

Im ersten Schritt erfolgt eine konventionelle, epitaktische Abscheidung einer ca. 20 nm dicken Siliziumkarbidschicht auf einem Silizium-Wafer. Die SiC-Schicht und die Siliziumoberflächenschicht zeigen dabei zunächst die typischen, von der Abscheidung aufgrund der 20 % igen Gitterfehlanpassung herrührenden Strukturdefekte.

Im zweiten Schritt wird durch Ionenimplantation Germanium, das heißt, ein den Schmelzpunkt von Silizium erniedrigendes Element, (Ionendosis 2 * 10 ¹⁷ cm⁻², Ionenenergie 120 keV, Implantationstemperatur 600 °C), eingebracht, wobei Energie, Implantationstemperatur und lonendosis so gewählt werden, dass im Silizium eine kristalline, gegenüber reinem Silizium um ca. 50 grd schmelzpunkterniedrigte Oberflächenschicht gebildet wird.

Im dritten Schritt wird das Schichtsystem einer Blitzlampenbestrahlung von 20 ms Dauer und einer Energiedichte oberhalb 110 Jcm⁻² unterzogen, wodurch die oberflächennahe Geangereicherte Siliziumschicht vollständig aufgeschmolzen wird, ohne dass die SiC-Schicht und die unterhalb der implantierte Schicht liegende Siliziumbereiche mit aufschmelzen. Nach Impulsende und Abkühlung der Probe erstarrt die flüssige Schicht epitaktisch auf dem ebenen und nicht geschmolzenen einkristallinen Siliziumsubstrat, während sich die SiC-Oberflächenschicht während der Schmelze der Si-Schicht mechanisch entspannt hat und aufgrund der hohen Temperatur ausgeheilt wurde. Im Ergebnis erhält man nach der Blitzlampenbestrahlung eine nahezu defektfreie heteroepitaktische Siliziumkarbid- auf-Silizium-Struktur.

## Patentansprüche

1. Verfahren zur Behandlung von Halbleitersubstratoberflächen, die mittels intensiven Lichtimpulsen kurzzeitig aufgeschmolzen werden, **gekennzeichnet dadurch, dass** auf der Halbleitersubstratoberfläche vor der Lichtimpulsbestrahlung eine im Schmelzpunkt gegenüber dem Substrat erniedrigte epitaktische Halbleiterschicht erzeugt wird.

2. Verfahren nach Anspruch 1, **dadurch gekennzeichnet, daß** die epitaktische Halbleiterschicht eine Germanium-angereicherte Siliziumschicht mit einem Germaniumgehalt zwischen 1 % und 10 % ist.

3. Verfahren nach Anspruch 1 **dadurch gekennzeichnet, dass** die epitaktische Halbleiterschicht mittels Ionenimplantation eingebracht wird

4. Verfahren nach Anspruch 1 bis 3, **dadurch gekennzeichnet, dass** in die epitaktische Halbleiterschicht zusätzlich Dotierungsatome eingebracht werden.

5. Verfahren nach Anspruch 1 bis 4, **dadurch gekennzeichnet, dass** nach Erzeugung der epitaktischen Halbleiterschicht und vor der Lichtimpulsbestrahlung eine Siliziumkarbid- Schicht epitaktisch abgeschieden wird.
